# EUROPÄISCHE PATENTSCHRIFT

(11) **EP 0 761 839 B1**
(45) Veröffentlichungstag und Bekanntmachung des Hinweises auf die Patenterteilung: **26.07.2000**
(21) Anmeldenummer: 96107655.1
(22) Anmeldetag: 14.05.1996
(51) Int. Cl.: C23C 14/50, B65G 47/90

(54) **Vorrichtung zum Greifen und Halten eines flachen Substrats**
Apparatus for gripping and holding a flat substrate
Dispositif de maintien et de préhension d'un échantillon plat

(30) Priorität: 11.08.1995 DE 19529537
(43) Veröffentlichungstag der Anmeldung: 12.03.1997
(73) Patentinhaber: Balzers und Leybold Deutschland Holding Aktiengesellschaft, 63450 Hanau (DE)
(72) Erfinder: Zejda, Jaroslav, 63517 Rodenbach (DE); Kempf, Stefan, 63755 Alzenau (DE)

(56) Entgegenhaltungen:
- DE-U- 9 307 263
- US-A- 4 599 037

## Beschreibung

Die Erfindung betrifft eine Vorrichtung zum Greifen und Halten eines flachen, vorzugsweise kreisscheibenförmigen Substrats mit einer zentralen Öffnung, beispielsweise einer Compact Disc, bestehend aus mehreren fingerförmigen, in einem Gehäuse kippbar gelagerten Greifern und einem im Gehäuse verschiebbar gelagerten Stempel oder Kolben mit einem auf die Greifer einwirkenden Kopfteil.

In der Vakuum-Prozeßtechnik - insbesondere in der Dünnschicht-Technik - ist das Beschichten von kreissscheibenförmigen Substraten, beispielsweise von Glas- oder Aluminiumscheiben für magnetische oder magneto-optische Datenträger bekannt. Diese scheibenförmigen Substrate werden als Speichermedien für digitale Information vielfältig verwendet. In einem Sputterprozeß werden beispielsweise geprägte Kunststoffscheiben mit einer Aluminiumschicht überzogen. Die hierzu eingesetzten Sputter-Beschichtungsanlagen besitzen in aller Regel eine automatisierte Handling-Einrichtung für die Beförderung der Substrate vor, in und hinter einer Vakuum-Kammer.

Von einem Puffer aus transportiert beispielsweise ein Schwenkarm eines Handling-Systems die Substrate in die Vakuum-Kammer. In der Kammer werden dann die Substrate auf einen Drehteller aufgelegt und mit diesem durch die einzelnen Stationen der Vakuum-Kammer hindurchbewegt. Zum Be- und Entladen der Drehteller mit den Substraten sind im Stand der Technik zahlreiche Vorrichtungen zum Greifen und Halten bekannt.

Bisher wurden in den Vakuum-Kammern meist solche Greifer verwendet, die mittels einer Vakuum-Schiebedurchführung von außerhalb der Kammer betätigt werden.

Diese bekannten Vorrichtungen haben den Nachteil, daß sie meist zu viele bewegte Teile enthalten, daß durch die Gleitbewegungen in den Schiebedurchführungen unerwünschte Partikel erzeugt werden, die später in den Beschichtungsraum gelangen und das Beschichtungsergebnis nachteilig beeinflussen. Weiterhin läßt sich bei solchen Schiebedurchführungen in aller Regel nach einer bestimmten Betriebsdauer ein Dichtungsverschleiß feststellen, der immer eine Leckage der Vakuum-Kammer und somit eine zeit- und kostenintensive Reparatur zur Folge hat.

Man hat bereits eine Vorrichtung vorgeschlagen (G 93 07 263.5) zum Greifen und Halten eines flachen, vorzugsweise scheibenförmigen Substrats, im wesentlichen bestehend aus mehreren Greifern und einer Membran aus elastischem Material, die eine in einem druckfesten Gehäuse angeordnete Öffnung verschließt, wobei auf der Vorder- und Rückseite der Membran unterschiedliche Drücke einstellbar sind und die Membran so angeordnet ist, daß sie bei anliegender Druckdifferenz eine Auslenkung aus ihrer Ruhelage ausführt und bei Druckgleichheit durch eine Druckfeder wieder in ihre Ruhelage zurückstellbar ist und wobei die Greifer mit ihrem jeweils einen Ende mechanisch mit der Membran so verbunden sind, daß sie mit ihrem anderen, freien Ende eine Schwenkbewegung proportional zur Auslenkung der Membran zum Greifen und Halten, beziehungsweise Freigeben des Substrats ausführen.

Aufgabe der vorliegenden Erfindung ist es nun, die Nachteile der bekannten Vorrichtung abzustellen und eine Vorrichtung anzugeben, die es erlaubt, Substrate inner- und außerhalb von Vakuum-Kammern besonders rasch und zuverlässig zu Greifen und zu Halten und die darüber hinaus besonders preiswert herstellbar ist.

Diese Aufgabe wird erfindungsgemäß dadurch gelöst, daß die Greifer in Öffnungen oder Durchbrüchen im Kopfteil des Gehäuses gehalten und geführt sind und eine Kippbewegung um eine Achse quer zur Längsachse des Gehäuses ausführen können, wobei die Schwenkachsen aller Greifer sich in einer Ebene erstrecken und zusammen ein die Längsachse umgreifendes gleichseitiges Vieleck bilden, wobei die dem Kolben zugekehrten Enden der Greifer gemeinsam von einem Ring aus elastischem Werkstoff oder einer Wurmfeder umgriffen sind, die sie gegen die die Kippbewegung begrenzende Anschlagflächen zieht.

Durch diese erfindungsgemäße Vorrichtung werden die Substrate vorteilhafterweise inner- und außerhalb von Vakuum-Kammern gegriffen und gehalten, wobei die Bewegungen nahezu verschleißfrei ausgeführt werden. Weiterhin wird durch die vorliegende Erfindung ein Höchstmaß an Schnelligkeit und Betriebssicherheit ermöglicht.

Weitere Einzelheiten und Merkmale ergeben sich aus den Unteransprüchen.

Die Erfindung läßt die verschiedensten Ausführungsmöglichkeiten zu, eine davon ist in den anhängenden Zeichnungen, die die Frontansicht und einen Schnitt zeigen, näher dargestellt.

Die Vorrichtung zum Greifen und Halten des Substrats 3 besteht im wesentlichen aus dem zylindrischen Gehäuse 4 mit Kopfteil 5, einem in einer Sacklochbohrung 6 des Gehäuses 4 längsverschiebbar gelagerten Kolben 7 mit pilzförmigem Druckstück 8, einem die Sacklochbohrung 6 nach oben zu verschließenden Deckel 9 mit Druckmittel-Anschlußbohrung 10, einem den Deckel 9 in seiner Lage sichernden Sprengring 11, drei fingerförmig ausgebildeten Greifern 12, 13, 14, einem alle drei Greifer 12, 13, 14 umschlingenden elastischen Ring, Band oder Wurmfeder 15 und drei, jeweils einen Greifer 12, 13, 14 umgreifende Lagerringe 16,...

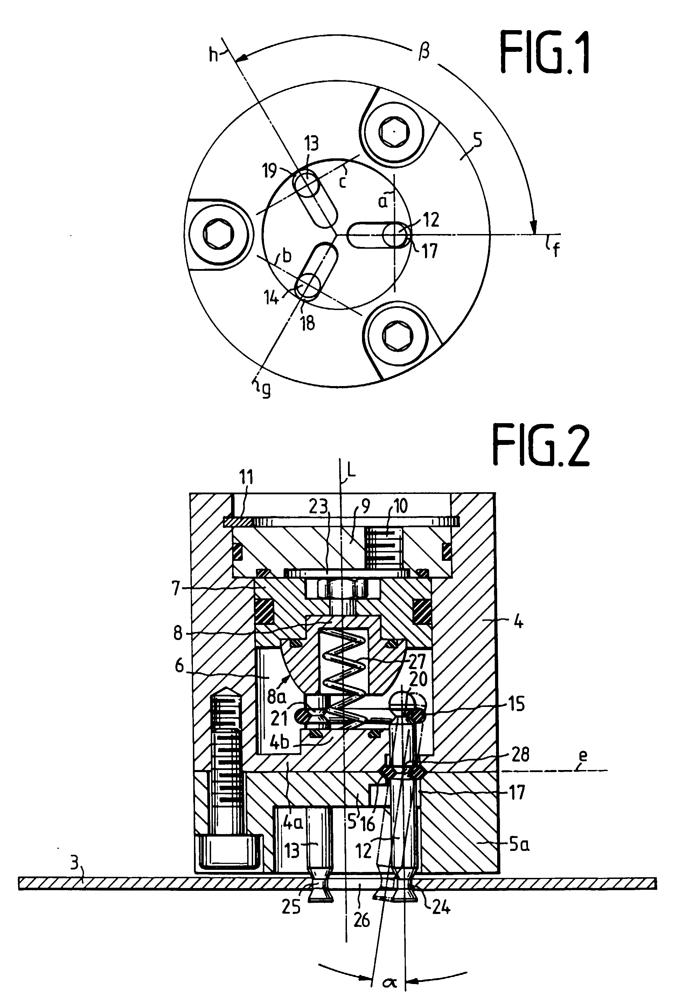

Wie die Zeichnung zeigt, sind die drei Greifer 12, 13, 14 jeweils in schachtartigen Durchbrüchen 17, 18, 19 angeordnet, die aus drei gleichartigen Öffnungen im Bodenteil 4a des Gehäuses 4 und drei gleichartigen Aussparungen im Bodenteil 5a des Kopfteils 5 gebildet und dabei so ausgeformt sind, daß die drei Greifer 12, 13, 14 jeweils von einer lotrechten Position (wie dargestellt) in eine leicht geneigte Position (wie strichliert angedeutet) um jeweils einen Winkel a von etwa 10° gekippt werden können, wobei jeder der Greifer 12, 13, 14 um seinen einerseits in einer Ringnut im Greifer und andererseits in einer Ringnut im Gehäuse 4, 5 gehaltenen Lagerring 16 um eine vertikale Achse a bzw. b bzw. c kippt.

Am oberen Ende jedes Greifers 12, 13, 14 befindet sich jeweils eine Ringnut 20, 21, 22, in die jeweils die Wurmfeder oder das elastische Band 15 eingreift und die Greifer 12, 13, 14 gegen die Anschläge am Bodenteil 4a zieht, wozu dieses Bodenteil 4a eine zentrische, zylindrische Amboß oder Nase 4b aufweist.

Wird nun der Raum 23 mit Druckmittel über den Anschluß 10 beaufschlagt, dann bewegt sich der Kolben 7 abwärts, wobei das pilzförmige Kopfteil 8a gegen die oberen Enden bzw. Kopfteile der Greifer 12, 13, 14 stößt und diese radial nach außen spreizt bzw. kippt mit der Wirkung, daß die unteren Enden der Greifer radial nach innen zu schwenken und zwar so weit, daß die Greifer bzw. die an ihren unteren Enden vorgesehenen ringförmigen Aussparungen oder Kerben 24, 25, ... von der zentralen Öffnung 26 des Substrats 3 frei kommen, so daß das Substrat 3 nach unten abfällt. Sobald der Druck im Raum 23 verringert wird, bewegt sich der Kolben 7 mit dem pilzförmigen Kopfteil 8a unter der Kraft der Druckfeder 27 wieder aufwärts und die Greifer 12, 13, 14 schwenken wieder in ihre Ausgangsposition, in der sich ihre Längsachsen parallel zueinander und parallel zur Achse L befinden.

### Bezugszeichenliste

- 3: Substrat
- 4: Gehäuse
- 4a: Bodenteil
- 4b: Nase
- 5: Kopfteil
- 5a: Bodenteil
- 6: Sacklochbohrung
- 7: Kolben
- 8: Druckstück
- 8a: Kopfteil
- 9: Deckel
- 10: Druckmittelanschluß
- 11: Sprengring
- 12: Greifer
- 13: Greifer
- 14: Greifer
- 15: elastisches Band, Wurmfeder
- 16: Lagerring
- 17: Durchbruch
- 18: Durchbruch
- 19: Durchbruch
- 20: Ringnut
- 21: Ringnut
- 23: Druckraum
- 24: Kerbe, Aussparung
- 25: Kerbe, Aussparung
- 26: zentrale Öffnung, Zentrierbohrung
- 27: Druckfeder
- 28,...: Ringnut

## Patentansprüche

1. Vorrichtung zum Greifen und Halten eines flachen, vorzugsweise kreisscheibenförmigen Substrats (3) mit einer zentralen Öffnung (26), beispielsweise einer Compact Disc, bestehend aus mehreren fingerförmigen, in einem Gehäuse (4,5) kippbar gelagerten Greifern (12,13,14) und einem im Gehäuse (4) verschiebbar gelagerten Stempel oder Kolben (7) mit einem auf die Greifer (12,13,14) einwirkenden Kopfteil (8a), **dadurch gekennzeichnet,** daß die Greifer in Öffnungen oder Durchbrüchen (17,18,19) im Kopfteil (5) des Gehäuses (4) gehalten und geführt sind und eine Kipp- oder Schwenkbewegung um eine Achse quer zur Längsachse (L) des Gehäuses (4,5) ausführen können, wobei die Kippachsen (a,b,c) aller Greifer sich in einer Ebene (e) erstrecken und zusammen ein die Längsachse (L) umgreifendes gleichseitiges Vieleck bilden, wobei die dem Kolben (7) zugekehrten Enden der Greifer (12,13,14) gemeinsam von einem Ring aus elastischem Werkstoff oder einer Wurmfeder (15) umgriffen sind, die sie gegen die Kippbewegung begrenzende Anschlagflächen (4b) zieht.

2. Vorrichtung nach Anspruch 1, **dadurch gekennzeichnet,** daß die Greifer (12,13,14) im Bereich der Ebene (e) der Kippachsen (a,b,c) jeweils mit einer Ringnut (28) versehen sind, wobei jede der Ringnuten (28,...) im Kippachsenbereich mit einem Ring (16,...) aus elastischem Werkstoff zusammenwirkt, der jeweils in einer Ringnut im Gehäuse (4,5) gehalten ist und eine Kippbewegung der Greifer (12,13,14) um einen Winkel (α) von etwa 10° unter Verformung der Ringe (16,...) ermöglicht.

3. Vorrichtung nach Anspruch 1, **dadurch gekennzeichnet,** daß die Öffnungen oder Durchbrüche (17,18,19) im Gehäuse (4,5) zur Halterung und Führung der Greifer (12,13,14) als ovale Langlöcher ausgebildet sind, deren Hauptachsen (f,g,h) die Gehäuselängsachse (L) schneiden, wobei die Hauptachsen (f,g,h) benachbarter Langlöcher gleiche Winkel (β) miteinander einschließen.

4. Vorrichtung nach den Ansprüchen 1 bis 3, **dadurch gekennzeichnet,** daß der Kolben (7) von einer Feder (27) beaufschlagt ist, die bei druckentlastetem Kolben (7) diesen in seine Ausgangsposition bewegt, in der das Druckstück (8) außer Kontakt mit dem oberen Ende der Greifer (12,13,14) gelangt.

5. Vorrichtung nach einem oder mehreren der vorhergehenden Ansprüche, **dadurch gekennzeichnet,** daß das Gehäuse mit sich radial erstrekkenden Sacklochbohrungen versehen ist, deren Längsachsen die Längsachsen der Greifer schneiden, wobei in jeder dieser Bohrungen ein Druckstück verschieblich gelagert ist, dessen aus der jeweiligen Bohrung herausragendes Kopfteil an einem Greifer anliegt und dessen anderes Ende von einer Feder beaufschlagt ist, wobei die Wirkrichtung so gewählt ist, daß die kippbar im Gehäuse gehaltenen und geführten Greifer in ihre lotrechte Position bewegt werden.

## Claims

1. A device for gripping and holding a flat, preferably circular disc-shaped substrate (3), having a central aperture (26), for example a compact disc, comprising a plurality of finger-shaped grippers (12, 13, 14) tiltably mounted in a housing (4, 5) and a ram or piston (7) displaceably mounted in the housing (4) with a headpiece (8a) acting upon the grippers (12, 13, 14), characterised in that the grippers are held and guided in apertures or openings (17, 18, 19) in the head (5) of the housing (4) and can execute a tilting or pivoting movement about an axis transverse to the longitudinal axis (L) of the housing (4, 5), the tilting axes (a, b, c) of all grippers extending in a plane (e) and together forming an equilateral polygon enclosing the longitudinal axis (L), the ends of the grippers (12, 13, 14) facing the piston (7) being enclosed together by a ring of elastic material or a worm spring (15), which pulls said grippers towards the abutment surfaces (4b) limiting the tilting movement.

2. A device according to claim 1, characterised in that the grippers (12, 13, 14) are provided in the region of the plane (e) of the tilting axes (a, b, c) with an annular groove (28) in each case, each of the annular grooves (28,...) cooperating in the region of the tilting axis with a ring (16,...) of elastic material, which is held in each case in an annular groove in the housing (4, 5) and allows for a tilting movement of the grippers (12, 13, 14) through an angle (α) of approximately 10° with a deformation of the rings (16,...).

3. A device according to claim 1, characterised in that the apertures or openings (17, 18, 19) in the housing (4, 5) are constructed for holding and guiding the grippers (12, 13, 14) as oval slots, whose main axes (f, g, h) intersect the housing longitudinal axis (L), the main axes (f, g, h) of adjacent slots forming equal angles (β) with one another.

4. A device according to claims 1 to 3, characterised in that the piston (7) is acted upon by a spring (27), which, when the piston (7) is relieved of pressure, displaces the piston into its starting position, in which the pressure element (8) disengages from the upper end of the grippers (12, 13, 14).

5. A device according to one or more of the preceding claims, characterised in that the housing is provided with radially extending blind bores, whose longitudinal axes intersect the longitudinal axes of the grippers, a pressure element being displaceably mounted in each of said bores, whose headpiece projecting from the respective bore rests against a gripper and whose other end is acted upon by a spring, the direction of action being selected in such a manner that the grippers, which are tiltably held and guided in the housing, are moved into their vertical position.

## Revendications

1. Dispositif pour saisir et maintenir un substrat plat (3), de préférence en forme de plaque circulaire pourvue d'une ouverture centrale (26), comme par exemple un disque compact, comprenant plusieurs éléments de saisie (12, 13, 14) en forme de doigts montés en basculement dans un boîtier (4, 5), et un poussoir ou un piston (7) monté en translation dans le boîtier (4), doté d'une partie de tête (8a) agissant sur les éléments de saisie (12, 13, 14),
caractérisé en ce que les éléments de saisie sont maintenus et guidés dans des ouvertures ou des traversées (17, 18, 19) dans la partie de tête (5) du boîtier (4) et peuvent exécuter un mouvement de basculement ou de pivotement autour d'un axe perpendiculaire à l'axe longitudinal (L) du boîtier (4, 5), les axes de basculement (a, b, c) de tous les éléments de saisie étant disposés dans un plan (e) et formant ensemble un polygone équilatéral qui entoure l'axe longitudinal (L), et les extrémités des éléments de saisie (12, 13, 14) tournées vers le piston (7) étant entourées conjointement par une bague en matériau élastique, ou par un ressort à boudin (15), qui les tire contre des surfaces de butée (4b) qui limitent le mouvement de basculement.

2. Dispositif selon la revendication 1, caractérisé en ce que les éléments de saisie (12, 13, 14) sont respectivement pourvus d'une gorge annulaire (28) dans la région du plan (e) des axes de basculement (a, b, c), chacune desdites gorges annulaires (28, ...) coopérant dans la zone de l'axe de basculement avec une bague (16, ...) en matériau élastique qui est respectivement maintenue dans une gorge annulaire dans le boîtier (4, 5) et qui permet un mouvement de basculement des éléments de saisie (12, 13, 14) sur un angle (α) d'environ 10° avec déformation des bagues (16,...).

3. Dispositif selon la revendication 1, caractérisé en ce que des ouvertures ou les traversées (17, 18, 19) dans le boîtier (4, 5) pour le maintien et le guidage des éléments de saisie (12, 13, 14) sont réalisées sous forme de trous allongés ovales dont les axes principaux (f, g, h) recoupent l'axe longitudinal du boîtier (L), et en ce que les axes principaux (f, g, h) de trous allongés voisins forment les uns avec les autres des angles égaux (β).

4. Dispositif selon les revendications 1 à 3, caractérisé en ce que le piston (7) est sollicité par un ressort (27) qui, lorsque le piston (7) est déchargé de la pression, déplace celui-ci jusque dans sa position de départ dans laquelle la pièce de pression (8) parvient hors de contact avec les extrémités supérieures des éléments de saisie (12, 13, 14).

5. Dispositif selon l'une ou plusieurs des revendications précédentes, caractérisé en ce que le boîtier est pourvu de perçages borgnes disposés radialement, dont les axes longitudinaux recoupent les axes longitudinaux des éléments de saisie, et en ce que dans chacun de ces perçages est montée une pièce de pression en translation, dont la partie de tête qui dépasse hors du perçage respectif est appuyée contre un élément de saisie, et dont l'autre extrémité est sollicitée par un ressort, et la direction d'action est ainsi choisie que les éléments de saisie maintenus et guidés en basculement dans le boîtier sont déplacés jusque dans leur position verticale.
